Europäisches Patentamt

**European Patent Office**

**Office européen des brevets**

(11) Veröffentlichungsnummer: **0 093 786**
**B1**

(12) **EUROPÄISCHE PATENTSCHRIFT**

(45) Veröffentlichungstag der Patentschrift:
06.08.86

(51) Int. Cl.⁴: **H 01 L 21/82**

(21) Anmeldenummer: **82103910.4**

(22) Anmeldetag: **06.05.82**

(54) Verfahren zum Herstellen einer planaren monolithisch integrierten Festkörperschaltung mit mindestens einem Isolierschicht-Feldeffekttransistor und mit mindestens einem Bipolartransistor.

(43) Veröffentlichungstag der Anmeldung:
16.11.83 Patentblatt 83/46

(45) Bekanntmachung des Hinweises auf die Patenterteilung:
06.08.86 Patentblatt 86/32

(84) Benannte Vertragsstaaten:
DE FR GB IT NL

(56) Entgegenhaltungen:
FR - A - 2 358 748
GB - A - 2 056 167
US - A - 4 058 887

IBM TECHNICAL DISCLOSURE BULLETIN, Band 22, Nr. 11, April 1980, Seiten 5146-5147, New York, USA E. BASSOUS et al.: "Self-aligned polysilicon gate MOSFETS with tailors source and drain profiles" JAPANESE JOURNAL OF APPLIED PHYSICS, Band 20, suppl. 20-1, 1981, Seiten 155-159, Tokyo, JP. T. SAKAI et al.: "High speed bipolar ICs using super self-aligned process technology"

(73) Patentinhaber: **Deutsche ITT Industries GmbH, Hans-Bunte-Strasse 19 Postfach 840, D-7800 Freiburg (DE)**
(84) Benannte Vertragsstaaten: **DE**

(73) Patentinhaber: **ITT INDUSTRIES INC., 320 Park Avenue, New York, NY 10022 (US)**
(84) Benannte Vertragsstaaten: **FR GB IT NL**

(72) Erfinder: **Blossfeld, Lothar, Dipl.-Phys., Waldstrasse 23, D-7800 Freiburg-Hochdorf (DE)**

(74) Vertreter: **Morstadt, Volker, Dipl.-Ing. et al, c/o Deutsche ITT Industries GmbH Patent/Lizenzabteilung Postfach 840 Hans-Bunte-Strasse 19, D-7800 Freiburg/Brsg. (DE)**

**Beschreibung**

Aus dem Buch von J.E. Carroll «Solid State Devices» (1980), Seiten 114 bis 117, ist ein Verfahren zum Herstellen einer planaren, monolithisch integrierten Festkörperschaltung mit mindestens einem Isolierschicht-Feldeffekttransistor und mindestens einem Bipolartransistor bekannt, deren Zonen in je eine Substratzone des ersten Leitungstyps an der einen Oberflächenseite eines halbleitenden Substrats aus Silicium des zweiten Leitungstyps eingesetzt sind. Bei diesem Verfahren werden mittels maskierter Implantationen von Ionen entsprechenden Leitungstyps die Dotierungen der Basiszone und der Emitterzone des Bipolartransistors in die erste Substratzone und die der Sourcezone und der Drainzone des Isolierschicht-Feldeffekttransistors in die andere Substratzone eingebracht und unter Aktivierung eindiffundiert.

Die Erfindung betrifft ein solches Verfahren gemäss dem Oberbegriff des Anspruchs 1.

Der mit dem bekannten Verfahren hergestellte Bipolartransistor der monolithisch integrierten Festkörperschaltung hat die Nachteile einer nicht selbsttätig zur Basiszone zentrierten Emitterzone und einer kompensierten Emitterzone, wodurch nur relativ kleine Stromverstärkungswerte und kleine Grenzfrequenzen realisierbar sind. Ein nicht-kompensierter Emitter hat nämlich nach «Techn. Digest IEDM» 1979, Seiten 514 bis 516, den Vorteil, dass relativ grosse Stromverstärkungswerte und erhöhte Grenzfrequenzen realisierbar sind. Ein weiterer Nachteil des mit dem bekannten Verfahren hergestellten Bipolartransistors beruht auf einem relativ hohen Basiswiderstand als Folge einer ungünstigen Verteilung der Basiszonendotierung, was wiederum die Grenzfrequenz ungünstig beeinflusst. Schliesslich hat das bekannte Verfahren der eingangs genannten Literaturstelle den Nachteil, dass zum Herstellen der Elektroden und Zuleitungen des Bipolartransistors drei Photolack-Maskierungsprozesse erforderlich sind.

Aufgabe der Erfindung ist daher die Angabe eines Verfahrens, das die Herstellung einer monolithisch integrierten Festkörperschaltung der betroffenen Art mit mindestens einem Bipolartransistor relativ grosser Stromverstärkung und hoher Grenzfrequenz und mindestens einem Feldeffekttransistor unter Anwendung möglichst weniger Photolackprozesse ermöglicht.

Diese Aufgabe wird erfindungsgemäss durch die im kennzeichnenden Teil des Anspruchs 1 angegebenen Massnahmen gelöst.

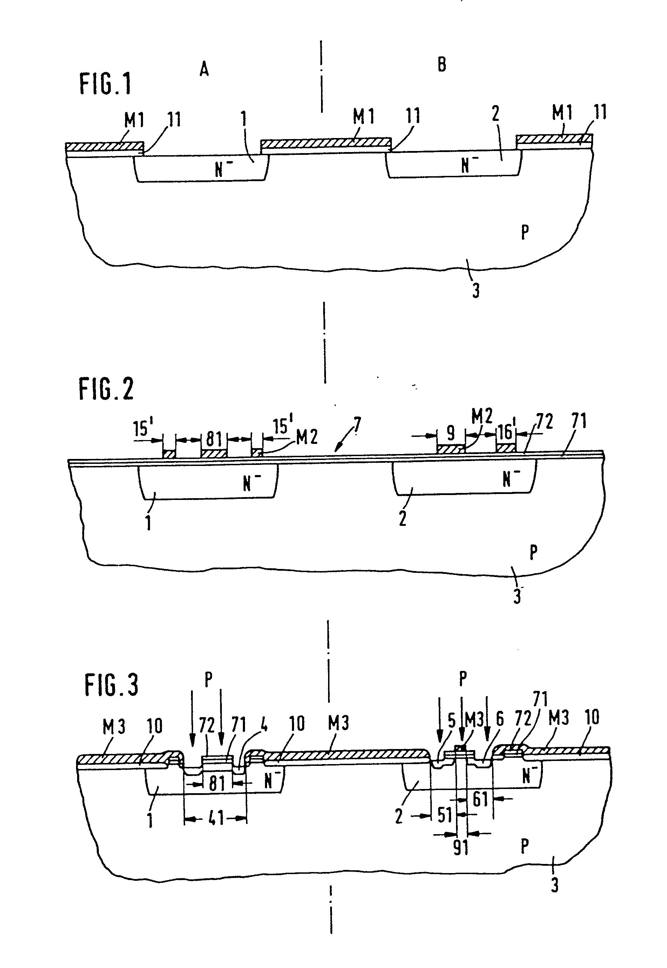

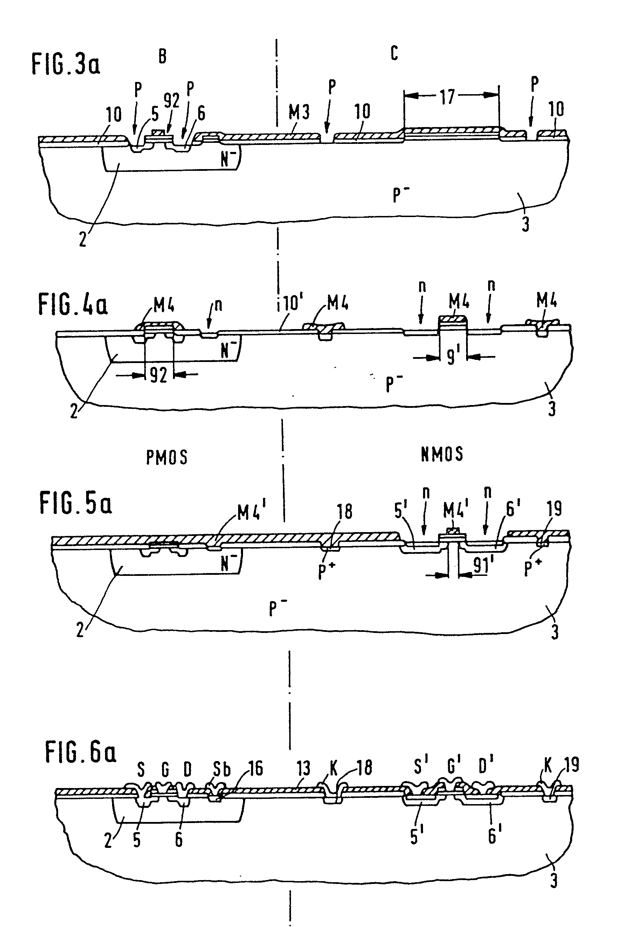

Die Merkmale und Vorteile des Verfahrens nach der Erfindung werden im folgenden anhand der Zeichnungen erläutert,

deren Fig. 1 bis 6 ausschnittsweise Querschnittsansichten durch einen plattenförmigen Halbleiterkörper zeigen, in welche ein bipolarer NPN-Planartransistor und ein P-Kanal-Feldeffekttransistor nach dem Verfahren der Erfindung hergestellt werden, und

deren Fig. 3a bis 6a zur Erläuterung einer Weiterbildung des Verfahrens nach der Erfindung dienen, welches die Herstellung von planaren integrierten Festkörperschaltungen mit Isolierschichtfeldeffekttransitoren von unterschiedlichem Kanalleitungstyp betrifft.

Die Fig. 1 bis 6 zeigen ausschnittsweise in üblicher Schnittdarstellung etwa senkrecht zur einen Oberflächenseite eines halbleitenden Substrats aus Silicium unter A aufeinander folgende Herstellungsstadien eines NPN-Bipolartransistors und unter B die zugeordneten Herstellungsstadien für einen PMOS-Feldeffekttransistor. Natürlich können auch die entgegengesetzten Leitungstypen zur Anwendung gelagen; im Hinblick auf schnelles Schalterverhalten werden jedoch NPN-Bipolartransistoren und P-Kanal-MOS-Feldeffekttransistoren vorgezogen, insbesondere, wenn letztere lediglich als Stromquellen und Lastwiderstände verwendet werden sollen.

Zum Zeitpunkt der Herstellung gemäss der Fig. 1 liegt ein Substratkörper 3 vor, in dessen eine Oberflächenseite in bekannter Weise unter Anwendung eines maskierten Ionenimplantationsprozesses die Dotierungen der Substratzonen 1 und 2 eingebracht und eindiffundiert wurden. Das Verfahren der Ionenimplantation zu diesem Zwecke empfiehlt sich im Hinblick auf die Einstellung der Feldschwellspannung des Feldeffekttransistors. Es können auch noch weitere maskierte Ionenimplantationen zur Einstellung der Feldschwellspannung oder auch des Typs des Feldeffekttransistors entsprechend der zuerst genannten Literaturstelle angewendet werden.

Entsprechend dem bekannten Stand der Technik werden zunächst unter Verwendung einer ersten Photolackmaske M1 die beiden Substratzonen 1 und 2 erzeugt, indem vorzugsweise die Dotierungen der Zonen durch eine Ionenimplantation in die Halbleiteroberflächenseite eingebracht werden. Die Photolackmaske M1 wird abgelöst, die Dotierungen werden eindiffundiert und schliesslich die Oxidmaske 11 abgelöst. Dann wird die Oberflächenseite mit einer Oxidationsmaskierungsschicht 7 bedeckt. Diese besteht aus einer unteren Isolatorteilschicht 71 und einer darauf abgeschiedenen oberen Nitridschicht 72 aus $Si_3N_4$, wobei entweder die untere Isolatorschicht 71 allein oder zusammen mit der Nitridschicht 72 der Zusammensetzung und Dikke der Gateisolatorschicht des Feldeffekttransistors entspricht. Beide Schichten zusammen können nämlich bei geeigneter Bemessung als Gateisolatorteilschichten von MNOS-Speichertransistoren der integrierten Festkörperschaltung verwendet werden.

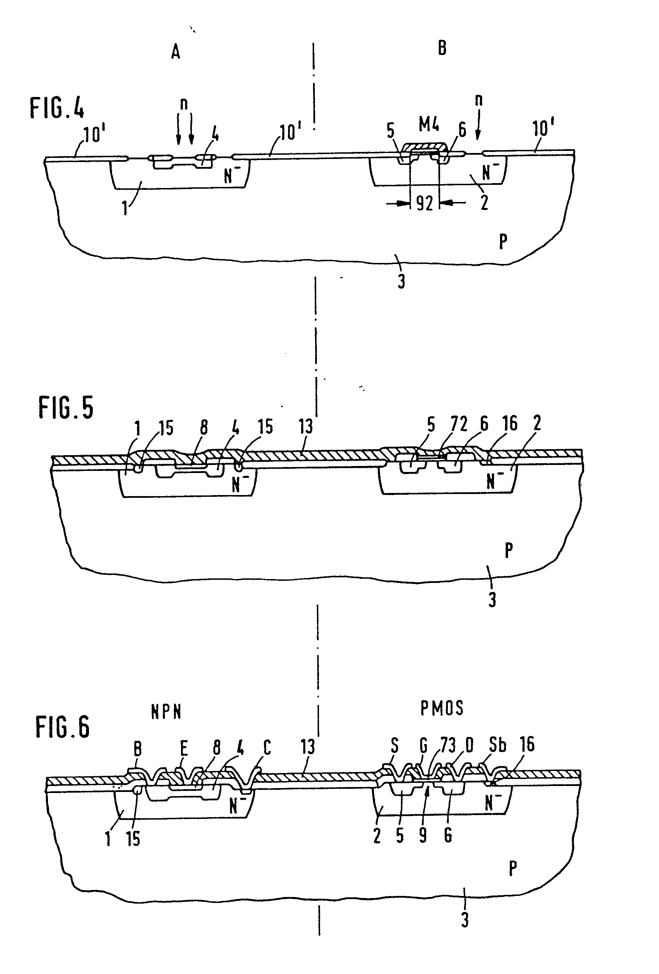

Wesentlich für die Erfindung ist aber, dass auf jeden Fall die zuoberst liegende Schicht eine Nitridschicht ist, welche aus $Si_3N_4$ bestehen kann, da diese beim Verfahren der Erfindung als Stopperschicht für den Ätzprozess einer Fremdoxidschicht 13 (vergl. Fig. 6) verwendet wird.

Auf die erwähnte Schichtenfolge mit der zuoberst liegenden Nitridschicht 72 wird nun zur Begrenzung eines Ätzprozesses die zweite Photolackmaske M2 aufgebracht, welche den Emitterbereich 81, einen mittleren Bereich 9 oberhalb des Gatebereichs 91 und angrenzende Bereiche der herzustellenden Sourcezone 5 und der herzustellenden Drainzone 6 sowie die Kontaktierungsbereiche 15' und 16' der Substratzone bedeckt, wie die Fig. 2 veranschaulicht.

Dann werden unter Verwendung der zweiten Photolackmaske M2 als Ätzmaske mittels eines Plasmaätzprozesses die freiliegenden Teile der Oxidationsmaskierungsschicht 7 durch Ätzung bis auf die Halbleiteroberfläche entfernt und danach die zweite Photolackmaske M2 abgelöst. Die freigelegten Teile der Oberflächenseite werden unter Bildung der Oxidschicht 10 oxidiert.

Danach wird eine dritte Photolackmaske M3 zur Begrenzung eines Ätzprozesses und eines Ionenimplantationsprozesses aufgebracht. Die Photolackmaske M3 begrenzt und definiert mit den stehengebliebenen Teilen der Oxidationsmaskierungsschicht 7 den Basisbereich 41, den Sourcebereich 51, den Drainbereich 61 und somit auch den Gatebereich 91. Die nicht von Photolack bedeckten Teile der Oxidschicht werden nun durch Ätzen entfernt, wie die Fig. 3 veranschaulicht.

Es erfolgen nun in beliebiger Reihenfolge zwei Implantationsprozesse von Ionen des gleichen Leitungstyps, wovon der eine mit relativ geringer Beschleunigungsenergie und relativ hoher Dosis und der andere mit relativ geringer Dosis und solch relativ grosser Beschleunigungsenergie durchgeführt werden, dass die Oxidationsmaskierungsschicht 7 durchdrungen wird. Dabei entsteht, wie aus der Fig. 3 ersichtlich, ein äusserer, relativ dicker Basiszonenteil ausserhalb des Emitterbereiches 81 und ein relativ dünner Basiszonenteil innerhalb des Emitterbereichs 81. In diesem Stadium wird die Grundlage für einen Bipolartransistor mit geringem Basiszonenzuleitungswiderstand und nichtkompensierter Emitterzone gelegt. Gleichzeitig entstehen dadurch, dass die dritte Photolackmaske M3 lediglich den Gatebereich 91 und nicht den gesamten mittleren Bereich 9 (vergleiche Fig. 2) oberhalb des Gatebereiches 91 bedeckt, die bereits als Sourcezone bzw. Drainzone 5 bzw. 6 anzusprechenden Dotierungsbereiche mit dünnen Ansätzen, welche den Gatebereich 91 definieren.

Nach Entfernung der dritten Photolackmaske M3 und der Oxidschicht 10 werden die nicht gegen eine Oxidation geschützten Oberflächenbereiche oxidiert, wobei eine neue von den stehengebliebenen Teilen der Oxidationsmaskierungsschicht unterbrochene Oxidschicht 10' entsteht, wie die Fig. 4 veranschaulicht. Eine vierte Photolackmaske M4 wird nun aufgebracht, welche den stehengebliebenen Teil 92 der Oxidationsmaskierungsschicht 7 innerhalb des mittleren Bereichs 9 des Gatebereichs 19 des Feldeffekttransistors bedeckt. An die vierte Photolackmaske M4 ist hinsichtlich der Begrenzung und Ausrichtung keine besondere Genauigkeit zu fordern, da der nach einer anschliessenden Ätzung erfolgende Ionenimplantationsprozess von der neuen Oxidschicht 10' begrenzt wird.

Anschliessend werden durch Ätzen aus der Gasphase (Plasmaätzung) die nicht von der vierten Photolackmaske M4 bedeckten Teile der Nitridschicht 72 und dann die darunterliegenden Teile der Isolatorschicht 71, wie sie in der Fig. 3 erkennbar sind, entfernt. Danach wird die Oberflächenseite der Anordnung mit Dotierungsionen des Leitungstyps der Emitterzone, beispielsweise mit Arsenionen, beschossen, so dass eine Anordnung gemäss der Fig. 4 entsteht.

Zum Schutz der Zonen, insbesondere deren Ränder, wird anschliessend nach Entfernung der vierten Photolackmaske M4 die Fremdoxidschicht 13 über die gesamte Anordnung aufgebracht, wie die Fig. 5 zeigt, und dann die Dotierungen unter dieser Fremdoxidschicht 13 bei erhöhter Temperatur aktiviert, wobei die Dotierungen geringfügig in den Halbleiterkörper diffundieren. Es entstehen dabei die Emitterzone 8 und die die Basiszone 4 vorzugsweise umgebene Kollektorkontaktierungszone 15 sowie die Kontaktierungszone 16 der Substratzone 2.

Anschliessend wird eine fünfte Photolackmaske verwendet, die bekanntlich zur Freilegung der kontaktierenden Zonen ohnehin erforderlich ist. Diese fünfte Maske dient aber beim Verfahren nach der Erfindung zusätzlich zur Freilegung der zuoberst im Gatebereich 91 liegenden Nitridschicht 72, so dass bei Verwendung einer zur Freilegung der kontaktierenden Zonen üblicherweise verwendeten Ätzlösung der Ätzprozess der Fremdoxidschicht 13 an der Nitridschicht 72 zum Stillstand kommt. Dadurch wird exakt die gewünschte Gateisolatorschicht des Isolierschicht-Feldeffekttransistors erhalten, da diese bereits anfänglich vorgegeben war. Es kann nun die Gateisolatorschicht 73 allein oder auch in Verbindung mit dem stehengebliebenen Teil der Nitridschicht 72 als Gateisolatorschicht verwendet werden. Im Falle der alleinigen Verwendung der unter der Nitridschicht 72 angeordneten Isolatorteilschicht wird die Nitridschicht selektiv entfernt, vorzugsweise unter Anwendung eines Plasmaätzprozesses.

Abschliessend werden unter Verwendung einer sechsten Photolackmaske in bekannter Weise mit Leiterbahnen versehene Kontakte B, E, C, S, D und der Substratkontakt Sb an den Zonen 1, 4, 8, 6, 2 angebracht, wobei aber gleichzeitig die Gateelektrode (G) mit deren Leiterbahn hergestellt wird.

Beim Verfahren der Erfindung wird also in besonderer Weise die gegen eine Ionenimplantation und selektive Ätzung maskierenden Eigenschaften von Oxidationsmaskierungsschichten mit zuoberst liegender Siliciumnitridschicht ausgenutzt, welche aus einer einheitlichen Isolatorschicht herausgeätzt werden, die zumindest in Teilschichten als Gateisolatorschicht eines Isolierschicht-Feldeffekttransistors verwendet wird.

Beim Verfahren der Erfindung ist insbesonders an die Herstellung von monolithisch integrierten Festkörperschaltungen mit NPN-Bipolartransistoren und P-Kanal-Feldeffekttransistoren gedacht, die als Lastelemente oder Stromquellen verwendet werden und deren Hochfrequenzeigenschaften von untergeordneter Bedeutung sind, während für die Bipolartransistoren optimale Hochfrequenzeigenschaften bzw. Eigenschaften einer Verwendung als schnelle Schalter zu stellen sind. Das Verfahren der Erfindung kann natürlich auch zur Herstellung von monolithisch integrierten Festkörperschaltungen mit Transistoren des anderen Leitungstyps angewendet werden. Das Verfahren nach der Erfindung kann aber auch hinsichtlich der Integration eines N-Kanal-Feldeffekttransistors zusätzlich zum NPN-Bipolartransistor weitergebildet oder abgewandelt werden. Zu diesem Zweck ist lediglich eine zusätzliche Photolackmaske erforderlich, welche einen zusätzlichen Ionenimplantationsprozess begrenzt.

Eine solche Weiterbildung des Verfahrens nach der Erfindung wird anhand der Fig. 3a bis 6a im folgenden erläutert. In diesen Figuren ist der Teil A der Fig. 1 bis 3 fortgelassen worden und angrenzend an den Teil B ist der Teil C des NMOS-Substratfeldeffekttransistor neben dem PMOS-Substratzonenfeldeffekttransistors dargestellt. Bei der Weiterbildung des Verfahrens nach der Erfindung wird zunächst so vorgegangen, wie anhand der Fig. 1 und 2 beschrieben wird.

Dann wird aber eine zweite Photolackmaske M2 aufgebracht, welche zusätzlich einen zur Herstellung des NMOS-Substrattransistors ausreichend grossen Oberflächenbereich 17 des Substrats 3 bedeckt, wie die Fig. 3a veranschaulicht.

Die Fig. 4a entspricht dem Stadium, wie es der Fig. 4 entspricht. Dazu wird nach Oxidation der freigelegten Oberflächenseite die Oxidschicht 10' durch thermische Oxidation gebildet und eine dritte Photolackmaske M3 aufgebracht, welche zusätzlich den genannten Oberflächenbereich 17 überlappend bedeckt, wonach die nicht vom Photolack bedeckten Teile der Oxidschicht 10' entfernt werden. Nach Implantation von Ionen des Leitungstyps des Substrats 3, wie in der Fig. 3a angedeutet wird, Entfernung der dritten Photolackmaske M3 und der Oxidschicht wie Bildung einer neuen Oxidschicht 10' wird anschliessend eine vierte Photolackmaske M4 aufgebracht, welche den stehengebliebenen Teil 92 der Oxidationsmaskierungsschicht 7 des PMOS-Feldeffekttransistors und einen mittleren Teil 9' des vorstehend genannten Oberflächenbereichs 17 oberhalb des Gatebereichs des weiteren NMOS-Substrat-Feldeffekttransistors bedeckt. Bei dem folgenden Ätzen aus der Gasphase wird somit beiderseits des mittleren Teils zu den Rändern der neuen Oxidschicht 10' hin je ein Teil der Halbleiteroberfläche freigelegt, wie die Fig. 4a zeigt.

Anhand der Fig. 5a, welche nicht dem Stadium der Fig. 5 entspricht, wird das Aufbringen einer weiteren Photolackmaske M4' und die Durchführung eines weiteren Implantationsprozess geschildert, wie zusätzlich zu den bereits anhand der Fig. 1 bis 6 erläuterten Verfahrensmassnahmen erforderlich ist. Nach der bereits erwähnten Implantation von Ionen des Leitungstyps der Emitterzone des Bipolartransistors und Entfernung der vierten Photolackmaske M4 wird nämlich eine weitere Photolackmaske M4' gemäss der Fig. 5a aufgebracht, welche den Gatebereich 91' des herzustellenden weiteren Feldeffekttransistors (NMOS) und zumindest die von der neuen Oxidschicht 10' nicht bedeckten Teile der Halbleiteroberfläche bedeckt. Es erfolgt nun, ähnlich wie anhand der Fig. 3 erläutert, ein Beschuss der Oberflächenseite der Anordnung gemäss der Fig. 5a mit weiteren Ionen vom Leitungstyp der Emitterzone mit einer solchen Beschleunigungsenergie, dass zwar die Oxidationsmaskierungsschicht durchdrungen wird, nicht aber die um die Photolackmaske M4' verstärkte. Es wird somit ein Feldeffekttransistor mit den Zonen 5' und 6' erhalten, die wie der PMOS-Feldeffekttransistor der Fig. 6 Ansätze aufweisen, die den Gatebereich 91' begrenzen.

Danach wird in gleicher Weise verfahren, wie anhand der Fig. 5 und 6 beschrieben wurde. Es werden also nach Entfernung der weiteren Photolackmaske M4' die als Ionen implantierten Dotierungen unter einer auf die Oberfläche der Anordnung aufgebrachten Fremdoxidschicht 13 bei erhöhter Temperatur aktiviert, wobei eine geringfügige Diffusion erfolgt. Die fünfte Photolackmaske enthält wie die sechste Photolackmaske zusätzliche Öffnungen, wie sie zur Freilegung der zu kontaktierenden Zonen und der zuoberst liegenden Nitridschicht erforderlich sind. Gleichzeitig mit der Gateelektrode G wird die Gateelektrode G' des NMOS-Feldeffekttransistors hergestellt, wobei wiederum als Stopperschicht die zuoberst liegende Nitridschicht 72 beim Durchätzen der Fremdoxidschicht 13 verwendet wird. Wiederum kann die zuoberst liegende Nitridschicht 72 vor der Herstellung der Gateelektroden durch einen selektiven Ätzprozess von der darunterliegenden Oxidschicht entfernt werden.

Die fünfte wie die sechste Photolackmaske können Öffnungen enthalten, welche zur Kontaktierung der Substratkontaktierungszonen 18 und 19 über Leiterbahnen verwendet werden. Die Dotierung dieser Substratkontaktierungszonen 18 und 19 erfolgt bei dem anhand der Fig. 3a geschilderten Ionenimplantationsprozess von Ionen des Leitungstyps des Substrats 3, wozu in der dritten Photolackmaske M3 Öffnungen vorgesehen sind, wie sie die Fig. 3a zeigt. Die Bereiche dieser Öffnungen sind mittels der vierten Photolackmaske M4 abzudecken, wie die Fig. 4a veranschaulicht.

**Patentansprüche**

1. Verfahren zum Herstellen einer planaren, monolithisch integrierten Festkörperschaltung mit mindestens einem Isolierschicht-Feldeffekttransistor und mindestens einem Bipolartransistor, deren Zonen in je eine unter Verwendung einer ersten Photolackmaske (M1) erzeugten Substratzone (1, 2) des ersten Leitungstyps an der einen Obeflächenseite eines halbleitenden Substrats (3) aus Silicium des zweiten Leitungstyps eingesetzt sind, wobei die Basiszone (4) des Bipolartransistors in die erste Substratzone (1) und die Zonen (5, 6) des Feldeffekttransistors in die zweite Substratzone (2) eindiffundiert werden, bei welchem Verfahren
die Dotierungen der Basiszone (4), der Sourcezone (5) mit denjenigen der Drainzone (6) sowie die der Emitterzone (8) mittels maskierter Implantationen von Ionen des zweiten bzw. des ersten Leitungstyps in die Substratzonen (1, 2) eingebracht und eindiffundiert werden, dadurch gekennzeichnet, dass nach der Erzeugung der Substratzonen (1, 2) die gesamte Oberflächenseite mit einer Oxidationsmaskierungsschicht (7) bedeckt wird, die aus einer auf der Substratzonenoberfläche angeordneten unteren Isolatorteilschicht (71) und einer zuoberst liegenden Nitridschicht (72) aus $Si_3N_4$ besteht, wobei hinsichtlich der Zusammensetzung und Dicke entweder die untere Isolatorteilschicht (71) allein oder zusammen mit der Nitridschicht (72) der Gateisolatorschicht des Feldeffekttransistors entspricht,
dass auf die Oberflächenseite eine zweite Photolackmaske (M2) aufgebracht wird, welche mindestens den Emitterbereich (81), einen mittleren Bereich (9) oberhalb des Gatebereiches (91) und angrenzende Bereiche oberhalb der Bereiche der herzustellenden Sourcezone (5) und der herzustellenden Drainzone (6) sowie die Kontaktierungsbereiche (15', 16') der Substratzonen (1, 2) überdeckt (Fig. 2),
dass anschliessend unter Verwendung der zweiten Photolackmaske (M2) als Ätzmaske die freiliegenden Teile der Oxidationsmaskierungsschicht (7) durch Ätzung bis auf die Halbleiteroberfläche entfernt werden, die zweite Photolackmaske (M2) abgelöst wird und die freigelegten Teile der Oberflächenseite unter Bildung einer Oxidschicht (10) oxidiert werden,
dass danach eine dritte Photolackmaske (M3) aufgebracht wird, welche mindestens den Basisbereich (41), den Sourcebereich (51) und den Drainbereich (61) begrenzt, und die nicht mit Photolack bedeckten Teile der Oxidschicht (10) durch Ätzen entfernt werden,
dass dann in beliebiger Reihenfolge die Oberfläche der Anordnung bei relativ geringer Beschleunigungsenergie und relativ hoher Dosis mit Dotierungsionen vom Leitungstyp der Basiszone bzw. der Sourcezone und der Drainzone und bei relativ grosser, das Durchdringen der Oxidationsmaskierungsschicht (7) bewirkender Beschleunigungsenergie und geringer Dosis beschossen wird (Fig. 3),
dass anschliessend nach Entfernung der dritten Photolackmaske (M3) und der Oxidschicht (10) die nicht gegen eine Oxidation geschützten Oberflächenbereiche unter Bildung einer neuen Oxidschicht (10) oxidiert werden,
dass dann eine vierte Photolackmaske (M4) aufgebracht, welche den stehengebliebenen Teil (92) der Oxidationsmaskierungsschicht (7) innerhalb des mittleren Bereichs (9) oberhalb des Gatebereichs (19) des Feldeffekttransistors bedeckt,
dass anschliessend durch Ätzen aus der Gasphase die nicht von der vierten Photolackmaske (M4) bedeckten Teile der Nitridschicht (72) und dann die darunter liegenden Teile der Isolatorschicht (71) durch Ätzen entfernt werden,
dass danach die Oberflächenseite der Anordnung mit Dotierungsionen des Leitungstyps der Emitterzone beschossen wird, (Fig. 4),
dass anschliessend nach Entfernung der vierten Photolackmaske (M4) die als Ionen implantierten Dotierungen unter einer auf die Oberfläche der Anordnung aufgebrachten Fremdoxidschicht (13) bei erhöhter Temperatur aktiviert werden (Fig. 5) und
dass schliesslich unter Verwendung einer fünften Photolackmaske die zu kontaktierenden Zonen und die zuoberst liegende Nitridschicht (72) freigelegt und unter Verwendung einer sechsten Photolackmaske über Leiterbahnen Kontakte (B, E, C; S, D, Sb) an den Zonen (1, 4, 8, 5, 6, 2) angebracht werden und gleichzeitig die Gateelektrode (G) mit deren Leiterbahn hergestellt wird.

2. Verfahren nach Anspruch 1, dadurch gekennzeichnet, dass eine zweite Photolackmaske (M2) aufgebracht wird, welche zusätzlich einen zur Herstellung eines weiteren Feldeffekttransistors (NMOS) ausreichend grossen Oberflächenbereich (17) des Substrats (3) bedeckt,
dass nach Oxidation der freigelegten Oberflächenseite unter Bildung der Oxidschicht (10) eine dritte Photolackmaske (M3) aufgebracht wird, welche zusätzlich den Oberflächenbereich (17) überlappend bedeckt, wonach die nicht vom Photolack bedeckten Teile der Oxidschicht (10) entfernt werden,
dass nach der Implantation von Ionen des Leitungstyps des Substrats (3), Entfernung der dritten Photolackmaske (M3) und der Oxidschicht (10) sowie Bildung einer neuen Oxidschicht (10') eine vierte Photolackmaske (M4) aufgebracht wird, welche den stehengebliebenen Teil (92) der Oxidationsmaskierungsschicht (7) des Feldeffekttransistors (PMOS) und einem mittleren Teil (9') des Oberflächenbereichs (17) oberhalb des Gatebereichs des herzustellenden weiteren Feldeffekttransistors (NMOS) bedeckt, so dass beiderseits des mittleren Teils (9') zur neuen Oxidschicht (10') hin je ein Teil der Halbleiteroberfläche bei dem Ätzen aus der Gasphase freigelegt wird (Fig. 4a),
dass nach der darauffolgenden Implantation von Ionen des Leitungstyps der Emitterzone des Bipolartransistors und Entfernung der vierten Photolackmaske (M4) eine weitere Photolackmaske (M4') aufgebracht wird, welche den Gatebereich (91') des herzustellenden weiteren Feldeffekttransistors (NMOS) und zumindest die von der neuen Oxidschicht (10') nicht bedeckten Teile der Halbleiteroberflächenseite bedeckt und
dass die Oberflächenseite mit weiteren Ionen vom Leitungstyp der Emitterzone mit einer solchen Beschleunigungsenergie beschossen wird, dass zwar die Oxidationsmaskierungsschicht allein, nicht aber die mit der weiteren Photolackmaske (M4') beschichtete, durchdrungen wird.

3. Verfahren nach Anspruch 1 oder 2, dadurch gekennzeichnet, dass die zuoberst im Gatebereich (91) liegende Nitridschicht (72) nach deren Freilegung vor der Herstellung der Gateelektrode (G) unter Anwendung einer selektiven Ätzung von der darunterliegenden Gateoxidschicht entfernt wird.

## Claims

1. Process for manufacturing a planar monolithic integrated solid-state circuit comprising at least one insulated-gate field-effect transistor and at least one bipolar transistor, with the regions thereof being introduced into each time one substrate region (1, 2), produced by employing a first photoresist mask (M1), of the first conductivity type on the one surface side of a semiconducting substrate (3) of silicon of the second conductivity type, with the base region (4) of the bipolar transistor being diffused into the first substrate region (1) and the regions (5, 6) of the field-effect transistor being diffused into the second substrate region (2), in which process the dopings for forming the base region (4), the source region (5) together with those of the drain region (6) as well as those of the emitter region (8) being introduced into the substrate regions (1, 2) by way of the masked implantations of ions of the second or the respective first conductivity type, and diffused, characterized in that subsequent to the production of the substrate regions (1, 2) the entire surface side is covered with an oxidation masking layer (7) which consists of a lower insulator partial layer (71) arranged on the surface of the substrate region, and of a topmost disposed nitride layer (72) of $Si_3N_4$, with said lower insulator partial layer (71) as regards the composition and thickness, and either alone or in combination with said nitride layer (72) corresponding to the gate insulator layer of the field-effect transistor,
that onto the surface side there is deposited a second photoresist mask (M2) which covers at least the emitter area (81), a central area (9) above the gate area (91) and adjacent areas above the areas of the source region (5) to be manufactured and the drain region (6) to be manufactured, as well as the contacting areas (15′, 16′) of the substrate regions (1, 2) (Fig. 2),
that after this, by employing the second photoresist mask (M2) as an etching mask, the exposed portions of the oxidation masking layer (7) are removed by way of etching down to the semiconductor surface, with the second photoresist mask (M2) being peeled off and the exposed portions of the surface side being oxidized by forming an oxide layer (10),
that thereafter a third photoresist mask (M3) is deposited which restricts at least the base area (41), the source area (51) and the drain area (61), and the portions of the oxide layer (10) which are not covered with photoresist, are removed by way of etching,
that then, in any arbitrary order of succession, the surface of the arrangement, at a relatively small accelerating energy and a relatively high dose of doping ions of the conductivity type of the base region or of the source region and the drain region, and at a relatively high accelerating energy effecting the penetration of the oxidation masking layer (7), and at a small dose, is bombarded (Fig. 3),
that after this and following the removal of the third photoresist mask (M3) and the oxide layer (10), those surface areas which are not protected against oxidation, are oxidized by forming a new oxide layer (10),
that then a fourth photoresist mask (M4) is deposited which covers the remaining portion (92) of the oxidation masking layer (7) within the central area (9) above the gate area (19) of the field-effect transistor,
that after this, by way of etching from the gaseous phase, the portions of the nitride layer (72) which are not covered by the fourth photoresist mask (M4), and thereafter the portions of the insulator layer (71) lying therebeneath, are removed by way of etching,
that thereafter the surface side of the arrangement is bombarded with doping ions of the conductivity type of the emitter region (Fig. 4),
that after this, and following the removal of the fourth photoresist mask (M4), the dopings implanted in the form of ions below a foreign oxide layer (13) deposited onto the surface of the arrangement, are activated at an increased temperature (Fig. 5), and
that finally, by employing a fifth photoresist mask, there are exposed the regions to be contacted as well as the topmost disposed nitride layer (72) and, by employing a sixth photoresist mask, contacts (B, E, C; S, D, Sb) are attached via conductor leads to the regions (1, 4, 8, 5, 6, 2) while simultaneously manufacturing the gate electrode G and the conductor lead thereof.

2. A process as claimed in claim 1, characterized in
that a second photoresist mask (M2) is deposited which additionally covers a sufficiently large surface area (17) of the substrate (3) for manufacturing a further field-effect transistor (NMOS),
that after the oxidation of the exposed surface side, by forming the oxide layer (10) there is deposited a third photoresist mask (M3) which additionally covers the surface area (17) overlappingly, whereupon those parts of the oxide layer (10) which are not covered by the photoresist, are removed,
that following the implantation of ions of the conductivity type of the substrate (3), the removal of both the third photoresist mask (M3) and the oxide layer (10) as well as the formation of a new oxide layer (10′), there is deposited a fourth photoresist mask (M4) which covers the remaining portion (92) of the oxidation masking layer (7) of the field-effect transistor (PMOS) and a central portion (9′) of the surface area (17) above the gate area of the further field-effect transistor (NMOS) to be manufactured, so that on both sides of the center portion (9′) towards the new oxide layer (10′) there is exposed each time one portion of the semiconductor surface, during the etching from the gaseous phase (Fig. 4a),

that after the subsequently following implantation of ions of the conductivity type of the emitter region of the bipolar transistor, and the removal of the fourth photoresist mask (M4), there is deposited a further photoresist mask (M4′) which covers the gate area (91′) of the further field-effect transistor (NMOS) to be manufactured and at least those portions on the semiconductor surface side which are not covered by the new oxide layer (10′), and

that the surface side is bombarded with further ions of the conductivity type of the emitter region, i.e., with such an accelerating energy that the oxidation masking layer alone but not the one coated with the further photoresist mask (M4′) is penetrated.

3. A process as claimed in claims 1 or 2, characterized in that the nitride layer (72) which is disposed topmost within the gate area (81), after the exposure thereof and prior to the manufacture of the gate electrode (G), is removed by employing a selective etching, from the gate oxide layer lying therebeneath.

**Revendications**

1. Procédé de fabrication d'un circuit intégré monolitique planar comprenant au moins un transistor à effet de champ à grille isolée et au moins un transistor bipolaire, dont les zones sont réalisées, pour chacun d'eux, dans une zone de substrat (1, 2) d'un premier type de conductibilité, produite en utilisant un premier masque photosensible (M1) sur une surface d'un substrat semi-conducteur (3) en silicium du second type de conductibilité, la zone de base (4) du transistor bipolaire étant diffusée dans la première zone de substrat (1) et les zones (5, 6) du transistor à effet de champ étant diffusées dans la seconde zone de substrat (2), procédé dans lequel:

les dopants formant la zone de base (4), la zone de source (5), ainsi que ceux de la zone de drain (6), de même que ceux de la zone d'émetteur (8) sont introduits dans les zones de substrat (1, 2) par implantation masquée d'ions respectivement du premier et du second type de conductibilité, puis sont diffusés, caractérisé en ce que: après la réalisation des zones de substrat (1, 2) la totalité de la surface est recouverte d'une couche de masquage d'oxydation (7) qui consiste en une couche partielle d'isolement inférieure (71) disposée à la surface de la zone de substrat et en une couche de nitrure (72) disposé par-dessus, en Si₃N₄, la couche partielle d'isolement inférieure (71), en ce qui concerne sa composition et son épaisseur, soit seule ou en combinaison avec ladite couche de nitrure (72), correspondant à la couche d'isolement de grille du transistor à effet de champ;

sur la surface, il est déposé un second masque photosensible (M2) qui recouvre au moins la région d'émetteur (81), une région centrale (9) au-dessus de la région de grille (91) et des régions adjacentes au-dessus de la région de source (5) à réaliser et de la région de drain (6) à réaliser, de même que des régions de contact (15′, 16′) des zones de substrat (1, 2) (fig. 2);

après cela, en employant le second masque photosensible (M2) comme masque d'attaque chimique, les parties exposées de la couche de masquage d'oxydation (7) sont enlevées par une attaque chimique allant jusqu'à la surface du semi-conducteur, le second masque photosensible (M2) étant arraché et les parties exposées de la surface étant oxydées par formation d'une couche d'oxyde (10),

ensuite, un troisième masque photosensible (M3) est déposé, lequel délimite au moins le domaine de base (41), le domaine de source (51) et le domaine de drain (61), les parties de la couche d'oxyde (10) non recouvertes de laque photosensible étant enlevées par attaque chimique,

puis, la surface du dispositif est bombardée, dans n'importe quel ordre de succession, sous une énergie d'accélération relativement faible et avec un dosage relativement élevé, par des ions du type de conductibilité de la région de base ou de la région de source et de la région de drain et, sous une énergie d'accélération relativement forte permettant de traverser la couche de masquage d'oxydation (7) et avec un dosage faible (fig. 3);

après cela et après l'enlèvement du trosième masque photosensible (M3) et de la couche d'oxyde (10), les régions de la surface qui ne sont pas protégées contre l'oxydation sont oxydées par formation d'une nouvelle couche d'oxyde (10);

ensuite, un quatrième masque photosensible (M4) est déposé, lequel recouvre les parties restantes (92) de la couche de masquage d'oxydation (7) dans le domaine central (9) au-dessus du domaine de grille (19) du transistor à effet de champ;

après cela, au moyen d'une attaque chimique en phase gazeuse, les parties de la couche de nitrure (72) qui ne sont pas couvertes par le quatrième masque photosensible (M4), suivies des parties de la couche d'isolement (71) se trouvant en-dessous, sont enlevées par attaque chimique;

alors, la surface du dispositif est bombardée par des ions dopants du type de conductibilité de la zone d'émetteur (fig. 4);

ensuite, et après enlèvement du quatrième masque photosensible (M4), les dopants implantés sous forme d'ions en dessous d'une couche d'oxyde apporté (13) déposée à la surface du dispositif, sont activés par une élévation de température (fig. 5) et

finalement, en employant un cinquième masque photosensible, les régions de contact sont exposées, de même que la couche de nitrure supérieure (72), et, en employant un sixième masque photosensible, des contacts (B, E, C; S, D, Sb) sont fixés par des parties conductrices aux différentes zones (1, 4, 8, 5, 6, 2), en même temps qu'est réalisée l'électrode de grille (G) et le conducteur correspondant.

2. Procédé selon la revendication 1, caractérisé en ce que:

un second masque photosensible (M2) est déposé, couvrant additionnellement un domaine de surface (17) du substrat (3) suffisamment grand pour la réalisation d'un autre transistor à effet de champ (NMOS);

après l'oxydation de la surface exposée formant la couche d'oxyde (10), il est déposé un troisième masque photosensible (M3) qui recouvre additionnellement ledit domaine de surface (17), après quoi les parties de la couche d'oxyde (10) qui ne sont pas couvertes de laque photosensible sont enlevées;

après l'implantation d'ions du type de conductibilité du substrat (3), l'enlèvement du troisième masque photosensible (M3) et de la couche d'oxyde (10), ainsi que la formation d'une nouvelle couche d'oxyde (10'), il est déposé un quatrième masque photosensible (M4) qui couvre les parties restantes (92) de la couche de masquage d'oxydation (7) du transistor à effet de champ (PMOS) et une partie centrale (9') du domaine de surface (17), au-dessus du domaine de grille du transistor à effet de champ additionnel (MNOS) à réaliser, de sorte que, des deux côtés de la partie centrale (9'), vers la nouvelle couche d'oxyde (10'), on découvre à chaque fois une partie de la surface du semi-conducteur, au cours de l'attaque ayant lieu en phase gazeuse (fig. 4a);

après l'implantation suivante d'ions du type de conductibilité de la zone d'émetteur du transistor bipolaire et l'enlèvement du quatrième masque photosensible (M4), il est déposé un autre masque photosensible (M4') qui couvre le domaine de grille (91') du transistor à effet de champ additionnel (MNOS) à réaliser et au moins les parties de la surface du semi-conducteur qui ne sont pas recouvertes par la nouvelle couche d'oxyde (10') et

la surface est bombardée par d'autres ions du type de conductibilité de la zone d'émetteur, avec une énergie d'accélération telle que la couche de masquage d'oxydation seulement, mais non pas celle qui est recouverte par l'autre masque photosensible (M4), est ainsi traversée.

3. Procédé selon l'une des revendications 1 ou 2, caractérisé en ce que la couche de nitrure (72) disposée au-dessus du domaine de grille (81), après exposition de celle-ci et avant la réalisation de l'électrode de grille (G), est enlevée de la couche d'oxyde de grille qui se trouve en dessous d'elle en employant une attaque chimique sélective.

FIG.1

FIG.2

FIG.3

FIG.3a

FIG.4a

FIG.5a

FIG.6a

0 093 786

FIG.4

FIG.5

FIG.6

13